# EUROPÄISCHE PATENTANMELDUNG

(11) **EP 3 249 559 A2**
(43) Veröffentlichungstag der Anmeldung: **29.11.2017**
(21) Anmeldenummer: 17000856.9
(22) Anmeldetag: 19.05.2017
(51) Int. Cl.: G06F 17/50

(54) **VORRICHTUNG, SYSTEM UND VERFAHREN ZUR ERGONOMISCHEN AUSLEGUNG VON KÜCHENEINRICHTUNGEN**

(30) Priorität: 24.05.2016 DE 102016006178
(71) Anmelder: Sales-M-learning GmbH, 53474 Bad Neuenahr-Ahrweiler (DE)
(72) Erfinder: NEUMANN, Markus, 53474 Bad Neuenahr-Ahrweiler (DE)
(74) Vertreter: Preusche, Rainer

(57) **Zusammenfassung**

Die Vorrichtung (10) zur Erhebung von einrichtungsbezogenen biometrischen Daten zur ergonomischen Auslegung von Kücheneinrichtungen weist eine Messeinrichtung (12) zum Messen von biometrischen Daten auf.

Das System (1) zur ergonomischen Auslegung von Kücheneinrichtungen umfasst wenigstens eine Messeinrichtung (12), wenigstens ein Sensorsystem (11) und eine Recheneinheit (16), wobei ein Algorithmus vorgesehen ist, mittels welchem Daten aus biometrischen Nutzerdaten gewonnener einrichtungsspezifischer Datensätze gewichtbar und mit Daten von Küchenelementdatensätzen vergleichbar sind.

Das Verfahren (100) zur computergestützten Erhebung von einrichtungsbezogenen biometrischen Daten umfasst zumindest die folgenden Schritte:
- Erheben (110) von biometrischen Daten;
- Speichern (120) der Daten in einem individuellen Datensatz;
- Übermittlung (130) des erhobenen Datensatzes an eine Recheneinheit;
- Auswerten (140) des Datensatzes zur Auslegung einer Einrichtung;
- computergestütztes Optimieren (150) einer Zuordnung von erhobenen Datensätzen zu einrichtungsspezifischen Datensätzen und
- Auswahl (160) und Zusammenstellung (170) von Einrichtungselementen.

## Beschreibung

Die Erfindung betrifft eine Vorrichtung, ein Verfahren und ein System zur Erhebung von biometrischen Daten, insbesondere von einrichtungsspezifischen Daten, zur ergonomischen Auslegung von Kücheneinrichtungen sowie die Verwendung der Vorrichtung.

Bei der im Stand der Technik üblichen Auslegung von Kücheneinrichtungen ist die bevorzugt und hauptsächlich verwendete Bezugsgröße die Größe des zur Verfügung stehenden Raumes. Kundenspezifische Daten wie beispielsweise die Körpergröße des Nutzers und Ergonomie sowie die Prävention von Unfällen, Fehlbelastungen, Haltungsschäden und anderen Gesundheitsgefahren werden in den gängigen Verfahren nicht oder nur unzureichend berücksichtigt. So können zwar Kücheneinrichtungen erstellt werden, welche perfekt an die Raumgröße angepasst sind, welche allerdings nicht auf den Kunden personalisiert sind. Dies ist insbesondere nachteilig, wenn der Nutzer beispielsweise eine von der durchschnittlichen Körpergröße abweichende Größe aufweist, was zu Problemen bei der Benutzung beispielsweise einer Kücheneinrichtung führen kann, da so z.B. einzelne Elemente ohne Hilfsmittel nicht oder nur unter Fehlbelastungen erreichbar sind oder die Benutzung von Elektrogeräten nicht uneingeschränkt möglich ist. So führt beispielsweise eine im Verhältnis zur Fußlänge zu geringe Sockeltiefe unter eine Arbeitsplatte dazu, dass ein Nutzer zu weit von der Arbeitsplatte entfernt steht, wodurch es zu Rückenproblemen kommen kann.

Aus dem Stand der Technik sind verschiedene Verfahren zur Herstellung von Möbeln bekannt. So offenbart die Druckschrift DE 102004036593 A1 zum Beispiel ein Verfahren zur Herstellung von Möbeln mit Hilfe von Computer-Programm-Produkten und digitaler Speichermedien. In diesem Verfahren werden Möbel aus verschiedenen Möbelteilen hergestellt. Hierbei werden von einem Kunden Wünsche hinsichtlich der Möbel in Form von Daten an eine Produktionseinrichtung übertragen und auf Grundlage der Kundewünsche wird ein entsprechendes Möbelstück erstellt. Weitere Daten werden für die Auslegung der Möbel nicht herangezogen.

Es ist Aufgabe der vorliegenden Erfindung eine Vorrichtung, ein Verfahren sowie ein System zur ergonomischen Auslegung von Kücheneinrichtungen vorzuschlagen, welche mit direkter Rückmeldung, einfach und fehlerunanfällig sowie präzise funktionieren, um eine Kücheneinrichtung, insbesondere zur Verhütung von Unfällen und/oder Haltungsschäden, optimal für Nutzer auszulegen und aufwändige Fehlplanungen und Fehlbestellungen zu vermeiden.

Diese Aufgabe wird durch die unabhängigen Ansprüche 1, 8 und 15 gelöst.

Erfindungsgemäß ist eine Vorrichtung zur Erhebung von einrichtungsbezogenen biometrischen Daten zur ergonomischen Auslegung von Kücheneinrichtungen vorgesehen, wobei die Vorrichtung eine Messeinrichtung zum Messen von biometrischen Daten aufweist. Um Kücheneinrichtungen an kundenspezifische Wünsche und Bedürfnisse anpassen zu können, werden die jeweiligen einrichtungsbezogenen biometrischen Daten des Kunden ermittelt. Als einrichtungsbezogen gelten im Sinne der Erfindung alle biometrischen Daten, die für die ergonomische Auslegung einer Einrichtung relevant sind. Diese Daten dienen als Grundlage für die Auslegung des jeweiligen Küchenelements. Ein Vorteil dabei ist, dass sich auf diese Weise eine Küche speziell auf die physischen bzw. biometrischen Merkmale des jeweiligen Nutzers anpassen lässt, wobei alle messbaren biometrischen Daten herangezogen werden, sodass die Gefahr von Unfällen und Haltungsschäden durch eine nicht ergonomische Küchenauslegung vermieden wird. Zusätzlich können weitere Daten in Bezug auf Geschmack, geplanter Küchenfunktion oder Preis einbezogen werden.

In einer vorteilhaften Ausgestaltung umfassen die durch die Vorrichtung gemessenen biometrischen Daten eine Ellbogenhöhe, Körpergröße, Schulterhöhe, Armlänge, Schuhgröße, Fußlänge, Hüfthöhe, Oberkörpergröße, Sehkraft, ein Hörvermögen, eine Greifhöhe, Tibialhöhe, Schritthöhe und/oder Fingerlänge. All diese Daten sind insbesondere relevant bei der Auslegung einer Küche. Dabei ist zum Beispiel die Ellenbogenhöhe ausschlaggebend für die Höhe der Arbeitsplatte, um eine für einen Benutzer der Küche angenehme Arbeitshöhe schaffen zu können.

Die Körpergröße und/oder Schulterhöhe in Verbindung mit der Armlänge dient beispielsweise der Auslegung der Oberschränke und/oder Elektrogeräte bezüglich ihrer Maße und ihrer Einbauhöhe. Unter einem Elektrogerät wird erfindungsgemäß beispielsweise ein Herd, Ofen, Geschirrspüler, Kühlschrank oder Gefrierschrank verstanden. Bei Oberschränken ist es wichtig, dass die Schränke in einer noch angenehm erreichbaren Höhe angeordnet sind, so dass alle in diesen Schränken verstauten Küchenutensilien bzw. Geschirr auch ohne weitere Hilfsmittel erreichbar sind. Dabei wird beispielsweise berücksichtigt, dass der Benutzer zur Vermeidung von Fehlbelastungen seine Arme bei Benutzung der Oberschränke nicht zu weit über eine horizontale Ebene nach oben neigen sollte, beispielsweise um höchstens 60°, insbesondere höchstens 45°, bevorzugt höchstens 30°.

Die Schuhgröße und/oder Fußlänge ist wichtig für die Auslegung von bodenständigen Küchenschränken. Um zu gewährleisten, dass der Benutzer der Küche möglichst nah an beispielsweise die Arbeitsplatte, den Herd oder auch die Oberschränke herantreten kann, wird auf Grundlage der Schuhgröße und/oder Fußlänge eine Aussparung, beispielsweise in Form einer passenden Sockeltiefe, an den bodenständigen Schränken angebracht.

Die Hüfthöhe in Verbindung mit der Oberkörpergröße und der Armlänge sind relevante Parameter bei der Auslegung der Tiefe der Arbeitsplatte und der Anbringung des Kochfeldes und/oder des Spülbeckens darauf.

Die Messung der Sehkraft ist insbesondere relevant bei der Ausgestaltung der Armaturen und Anzeigen. Bei schlechter Sehkraft können bzw. müssen etwaige Anzeigen oder Armaturen dementsprechend groß ausgestaltet sein, damit die Informationen für einen Benutzer der Küche gut lesbar und eindeutig identifizierbar sind. So ist es zum Beispiel bei einer digitalen Anzeige für den Backofen wichtig, dass gut erkennbar ist, welche Temperatur eingestellt ist und, falls integriert, welche Back- bzw. Garzeit eingestellt ist. Somit wird die Bedienbarkeit der Küchengeräte für einen Benutzer mit verminderter bzw. beeinträchtigter Sehkraft erleichtert. Ebenso ist das Hörvermögen ausschlaggebend bei der Auswahl von Elektrogeräten mit akustischen Warnsignalen.

Weiterhin kann durch das Messen der Fingerlänge die Tiefe der Aussparungen der Griffe, beispielsweise an Schüben, Elektrogeräten und Schränken, individuell angepasst werden. Die Greifhöhe, das heißt die Höhe des Handgelenks des aufrecht stehenden Benutzers über dem Boden bei herabhängendem Arm, kann zur optimalen Höhenpositionierung der Griffe genutzt werden.

Eine Kombination der Armlänge mit der Greifhöhe und/oder der Schulterhöhe kann beispielsweise eine Einbauhöhe eines Backofens definieren. Dadurch wird zum Beispiel verhindert, dass aus einem zu hoch eingebauten Backofen Backbleche und/oder Backformen nur schwer entnommen werden können, wodurch es zu schweren Verbrennungen kommen kann.

Die Schritthöhe definiert die Schrittlänge des Benutzers und somit eine optimale Anordnung unterschiedlicher Küchenmöbel zueinander, um optimale Laufwege für typische Arbeitsabläufe in der Küche zu erreichen, zum Beispiel Lebensmittel in einer Spüle abwaschen - Lebensmittel auf einer Arbeitsplatte verarbeiten - Lebensmittel auf einem Herd garen.

Die Tibialhöhe definiert die Höhe des Knies des aufrecht stehenden Benutzers über dem Boden. Erfahrungsgemäß sind Zusammenstöße mit Küchenmöbeln im Beinbereich besonders schmerzhaft und verletzungsgefährlich, wenn sie ein Knie treffen. Daher werden hervorstehende Teile von Küchenmöbeln und/oder Elektrogeräten, beispielsweise Auszüge, Schubladen oder Türen, mit Hilfe der Tibialhöhe vorteilhafterweise in einer Höhe angeordnet, in der sie nicht auf ein Knie treffen können.

Die Anpassung der einzelnen Elemente an die vorhandene Raumgröße wird vorzugsweise erst in einem späteren Schritt vorgenommen.

Erfindungsgemäß können insbesondere die Vorlieben und/oder biometrischen Daten sowie andere Randbedingungen, wie Seh- oder Gehbehinderungen, Budget oder technische Vorgaben (wie die maximale Heiztemperatur eines Herdes oder Sicherheitsmaßnahmen), in einem Nutzerdatensatz parametrisiert werden. Ein Vorteil der Erfindung ist, genau die für die Zweckbestimmung notwendigen biometrischen Daten zu erfassen, um den zu vermessenden Nutzer zeitsparend beraten zu können und ressourceneffizient ein Optimierungsergebnis zu ermitteln.

Ferner können Einrichtungsgegenstände auf die Eignung für Nutzer, technische Daten, Kosten oder Verfügbarkeit, mit den parametrisierten Nutzerdaten in Einrichtungsdaten parametrisiert werden. Die Erfindung kann insbesondere statt eines Einzelnutzers auch eine Nutzergruppe, wie beispielsweise eine Familie, Wohngemeinschaft oder Bürögemeinschaft, zugrunde legen. Unter den Nutzern, die stark unterschiedliche biometrische Parameter und sonstig Maßgaben an eine Kücheneinrichtung haben können, kann erfindungsgemäß eine Wichtung vorgenommen werden. Beispielsweise kann eine Kücheneinrichtung so optimiert werden, dass sie auch für einen gehbehinderten Nutzer rollstuhlgerecht zu bedienen ist oder für bestimmte Kochzwecke, wie etwa einem offenen Grill, ausgelegt ist. Solche Kriterien können erfindungsgemäß als Muss-Kriterien für die Küchenauslegung definiert werden. Besonders vorteilhaft ist die Auslegung anhand einer Nutzergruppe beispielsweise von Kücheneinrichtungen oder anderen Einrichtungen, die von einer Vielzahl von Nutzern benutzt werden, wie zum Beispiel in Ausbildungseinrichtungen, Mieträumen oder Hotelzimmern. In solchen Fällen kann für eine Nutzergruppe ein abstraktes Profil allgemein komfortabel und ergonomisch nutzbarer z.B. Kücheneinrichtungen definiert werden, das durch die technische, vorzugsweise computergestützte, Optimierung stets berücksichtigt wird und bleibt, selbst wenn eine Vielzahl von Einzelparametern mit unüberschaubaren Korrelationen auf andere Parameter und mithin das Gesamtergebnis verändert werden. Dies ist ohne technische Mittel nicht zu leisten. Vorteilhaft wird der Planungsprozess für eine Kücheneinrichtung effizient gestaltet, und aufwändige Fehlplanungen werden vermieden.

Insbesondere durch einen computergestützten Algorithmus können die Nutzerdaten mit den Einrichtungsdaten korreliert werden, um Arrangementdaten für das Arrangement von Einrichtungsgegenständen, wie einer Kücheneinrichtung, zu generieren.

Die Daten im Nutzerdatensatz können manuell je nach Vorliebe des Nutzers gewichtet werden, beispielsweise durch Eingabe an einem beispielsweise webbasierten Nutzerinterface.

Die Daten im Nutzerdatensatz können auch von einem Algorithmus aufgrund von Erfahrungswerten oder modischen Trends gewichtet werden. Der Algorithmus kann insbesondere ein selbstlernender Algorithmus, wie z. B. ein neurales Netz-basierter Algorithmus sein.

Denkbar ist auch die Optimierung auf mehrere Arrangementdatensätze gemäß von Vorlieben wie "gemütlich", konservativ, klassisch, sicherheitsbetont, modern, avantgardistisch und anderes. Diese Vorgaben können erfindungsgemäß ebenfalls parametrisiert werden und insbesondere Eingang in die Gewichtungsfaktoren für die Nutzerdatensätze und/oder Einrichtungsdatensätze finden. Beispielsweise kann so ein moderner Backofen mit Touchdisplay-Bedienung für einen Nutzer mit klassischen Vorlieben untergewichtet oder ausgeschlossen werden.

Ferner kann ein erfindungsgemäßer Algorithmus die Kompatibilität gemäß technischen, designerischen oder kostenmäßigen Gesichtspunkten berücksichtigen. Denkbar sind auch nutzerbedingte Kriterien wie der Auslegung der Einzelmodule einer Kücheneinrichtung auf bestimmte körperliche oder gesundheitliche Maßgaben oder Einschränkungen. Beispielswiese in diesem Fall empfiehlt es sich, einen Abgleich mit einer Datenbank an heuristischen Daten vorzunehmen, um das Arrangement einer Kücheneinrichtung auch aufgrund von allgemeinen oder gruppenbezogenen Kriterien, wie beispielsweise der Gruppe der Seh- oder Gehbehinderten, zu optimieren. Ein technischer Vorteil der erfindungsgemäßen Computerstützung des Verfahrens liegt darin, dass ohne computergestützte Einbeziehung die Vielzahl der technischen und sonstigen die technische Auslegung einer Kücheneinrichtung beeinflussenden Parameter nicht und zumal nicht in Echtzeit handhabbar ist. Der Begriff Echtzeit ist erfindungsgemäß beispielsweise auf die typische Zeitspanne eines Beratungsgespräches für eine Kücheneinrichtung bezogen, innerhalb derer vorteilhafterweise ein oder bevorzugt mehrere qualifizierte Vorschläge unterbreitet werden sollen. Dieses Konzept ist erfindungsgemäß auch auf andere Einrichtungsarrangements übertragbar.

Die Vorrichtung weist in einer weiteren vorteilhaften Ausgestaltung ein Sensorsystem zur automatischen Erfassung der gemessenen Daten mit einer Datenschnittstelle auf, wobei die Datenschnittstelle zur Übertragung der erhobenen Daten an eine Recheneinheit ausgestaltet ist oder das Sensorsystem mit der Recheneinheit eine Einheit bildet. Eine Einheit zwischen Sensorsystem und Recheneinheit kann zum Beispiel durch ein Tablet oder einen Laptop realisiert sein, auf welchem ein Programm zur Erhebung von biometrischen Daten ausgeführt wird, welches die von der Messeinrichtung gemessenen Daten empfängt. In einer weiteren vorteilhaften Ausführungsform sind die Daten kabellos übertragbar, falls das Sensorsystem mit der Recheneinheit keine Einheit bildet. Vorteilhaft an einer kabellosen Übertragung ist, dass keine möglicherweise hinderlichen Kabel zwischen Sensorsystem und Recheneinheit verlegt sein müssen.

Die Vorrichtung ist vorteilhaft mobil ausgestaltet. Eine mobile Variante weist beispielsweise Rollen auf und kann zum Beispiel mittels eines Elektromotors verfahrbar oder verschiebbar ausgestaltet sein, um die Vorrichtung in einem Einrichtungshaus an mehreren Orten nutzen zu können. Eine Motorunterstützung ist vorteilhaft, da die Vorrichtung in ihrer Gesamtheit eine Höhe aufweisen muss, um die gesamte Körpergröße eines jeden Kunden messen zu können. Demnach weist die Vorrichtung bevorzugt eine maximale Höhe zwischen 180 - 250 cm, bevorzugter 190 - 230 cm und mehr bevorzugt zwischen 200 - 220 cm auf. Die maximale Breite der Vorrichtung beträgt wenigstens 100 cm und höchstens 200 cm. Besonders vorteilhaft sind die Messeinrichtungen entlang der Höhe und der Breite verfahrbar, so dass alle Körpergrößen bis zu der maximalen Höhe und Breite ebenfalls gemessen werden können.

In einer vorteilhaften Ausgestaltung weist die Vorrichtung eine Einrichtung zur Dateneingabe auf. Eine derartige Einrichtung ist vorteilhaft, da so nachträglich nach dem Erstellen eines Vorschlags für eine Kücheneinrichtung spezielle Anpassungen an Kundenwünsche möglich sind. So können zum Beispiel Präferenzen bzgl. Preisrahmen, Farbe der Einrichtung, Material der Arbeitsplatte, Material der Schränke und/oder bzgl. des Fabrikats der einzubauenden Elektrogeräte umgesetzt werden. Dies ist besonders vorteilhaft, da solche Vorlieben nicht durch biometrische Daten gemessen werden können. Allerdings können derartige Faktoren für den jeweiligen Kunden für einen Kauf einer Kücheneinrichtung ausschlaggebend sein. So wird sichergestellt, dass alle möglichen Personalisierungsmöglichkeiten verwirklicht werden. Weiterhin können auf diese Weise Daten zur Raumgröße in das Verfahren mit einbezogen werden, was unmittelbar Auswirkungen auf die Auslegung der einzelnen Einrichtungsteile haben kann. Zudem ist es möglich über diese Eingabe bereits bekannte biometrische Daten, wie zum Beispiel die Körpergröße direkt einzugeben, so dass der Messvorgang nicht alle Schritte abarbeiten muss, was zu einer Beschleunigung des Vorgangs führt.

Die Erfindung betrifft weiterhin die Verwendung der Vorrichtung zur ergonomischen Auslegung von Kücheneinrichtungen, wobei die Vorrichtung nach einem der Ansprüche 1 bis 6 ausgestaltet ist.

Erfindungsgemäß ist weiterhin ein Verfahren zur computergestützten Erhebung von einrichtungsbezogenen biometrischen Daten zur ergonomischen Auslegung von Kücheneinrichtungen vorgesehen, wobei das Verfahren zumindest die folgenden Schritte umfasst:
- Erheben von biometrischen Daten;
- Speichern der Daten in einem individuellen Datensatz;
- Übermittlung des erhobenen Datensatzes an eine Recheneinheit;
- Auswerten des Datensatzes zur Auslegung einer Kücheneinrichtung;
- computergestütztes Optimieren einer Zuordnung von erhobenen Datensätzen zu spezifischen Küchenelementdatensätzen;
- Auswahl und Zusammenstellung von Küchenelementen.

Zur Auswertung des Datensatzes werden aus den biometrischen Daten, gegebenenfalls nach einer gewichteten Zusammenfassung der Daten mehrerer Nutzer, Merkmale einer Einrichtung ermittelt, die eine ergonomische Nutzung erlauben. Beispielsweise kann aus der Schuhgröße, beziehungsweise Fußlänge eines Nutzers die optimale Sockeltiefe bodenständiger Einrichtungsgegenstände ermittelt werden. Um die Zuordnung der biometrischen Datensätze zu Küchenelementdatensätzen zu ermöglichen, sind zu jedem Küchenelement die möglichen Ausprägungen der ergonomierelevanten Merkmale, wie beispielsweise Abmessungen, Griffpositionen oder Einbauhöhe, sowie Angaben zur Kompatibilität mit anderen Küchenelementen in Küchenelementdatensätzen hinterlegt. So können die zu den biometrischen Daten passenden Küchenelemente mit den passenden Merkmalsausprägungen ausgewählt und zusammengestellt werden. Insbesondere wenn eine Vielzahl von biometrischen Daten zur Ermittlung einer Vielzahl von passenden Markmalen der Küchenelemente eingesetzt werden soll, um eine möglichst umfassende Optimierung der Kücheneinrichtung zu erreichen, kann das Optimieren nur computergestützt zeit- und kosteneffizient umgesetzt werden.

In einer vorteilhaften Ausführung des Verfahrens wird als Resultat der Auslegung ein, insbesondere dreidimensionaler, Raumplan erstellt. Ein derartiger Raumplan ist vorteilhaft, da der Kunde direkt die gesamte Kücheneinrichtung, insbesondere dreidimensional, betrachten kann und gegebenenfalls sofort Änderungswünsche z.B. hinsichtlich der Anordnung der einzelnen Elemente äußern kann. Wenn das Resultat der Auslegung Bereiche enthält, die von einem Nutzer aufgrund seiner biometrischen Daten nicht oder nur unter Fehlbelastungen erreichbar sind und/oder Gefahrenquellen darstellen, werden diese Bereiche vorteilhafterweise in dem Raumplan als Warnzonen markiert. Auf diese Weise kann der Kunde und/oder ein Kundenberater potentielle Gefahrenquellen der Kücheneinrichtung erkennen und gegebenenfalls durch Änderungen, beispielsweise an nutzerspezifischen Zusatzdaten und/oder an einer manuellen Anpassung von Küchenelementen, eliminieren.

Vorteilhaft ist weiterhin, dass nach der Auswahl die Küchenelemente manuell an spezielle Anforderungen angepasst werden können. Diese Anforderungen können spezielle Farbauswahl, Material der Arbeitsplatte, Material der Kücheneinrichtung, der Preisrahmen und/oder das Fabrikat der einzubauenden Elektrogeräte sein.

Insbesondere nach einer manuellen Anpassung der Auswahl ist es vorteilhaft, wenn das Verfahren ein Bewerten der Auswahl, beispielsweise bezüglich einer Nutzungssicherheit, technischen Kompatibilität und/oder Kompatibilität zu biometrischen Nutzerdaten und/oder nutzerbezogenen Zusatzdaten umfasst. Das Bewerten kann beispielsweise durch ein Computerprogramm erfolgen, das das Ergebnis des Bewertens, insbesondere zusammen mit einem Resultat der Auslegung, beispielsweise in einem Ampelsystem und/oder Schulnotensystem und/oder als Prozentwert, anzeigt.

Das Verfahren kann neben biometrischen Daten auch die Erhebung und/oder Verarbeitung nutzerbezogener Zusatzdaten umfassen, die für die Auslegung einer Einrichtung relevant sind. Die Zusatzdaten können beispielsweise Präferenzen bezüglich Farb- und Materialauswahl, Anforderungen an die technische Ausstattung, Anforderungen zur Barrierefreiheit, Maße des einzurichtenden Raumes und/oder Preisvorstellungen umfassen. Durch die Einbeziehung von Zusatzdaten kann die Einrichtung vorteilhafterweise nicht nur an die ergonomischen sondern auch an andere Anforderungen des Nutzers angepasst werden, die seine Kaufentscheidung beeinflussen.

Die biometrischen Daten und/oder nutzerbezogenen Zusatzdaten können auch von einer Nutzergruppe mit einer Mehrzahl von Nutzern erhoben werde. Bevorzugt wird eine Wichtung unter den Nutzern, besonders bevorzugt als bezogen auf den Nutzzweck der Kücheneinrichtung wichtige Parameter der einzelnen Nutzer, vorgenommen. So kann die Küche für die gesamte Nutzergruppe zweckgemäß nutzbar ausgelegt werden, auch für den Nutzer der Nutzergruppe mit den schwierigsten Anforderungen.

Biometrische Daten und/oder nutzerbezogene Zusatzdaten können zusammen mit den Auswertungsergebnissen in einer Datenbank gespeichert werden. Aus dieser Datenbank kann ermittelt werden, welche Einrichtungseigenschaften für welche Nutzergruppen, insbesondere unter ergonomischen Gesichtspunkten, besonders geeignet sind. Mit diesen Informationen kann vorteilhafterweise die Einrichtungsproduktionsplanung und/oder das Einrichtungsdesign herstellerseitig an den Kundenbedarf angepasst werden. Durch diese Anpassung an den Kundenbedarf kann die kostspielige Produktion von Ladenhütern vermieden werden.

Das erfindungsgemäße Verfahren kann insbesondere auf einer Internet-Plattform ausgeführt werden. Dabei kann ein Nutzer beispielsweise über einen Internet-Browser biometrische Daten, Körpermaße, spezielle Anforderungen, beispielsweise durch körperliche Beeinträchtigungen, bevorzugte Farben und Materialien, Preisvorstellungen und/oder Raummaße eingeben. Ein Server kann aus den eingegebenen Daten geeignete Einrichtungselemente auswählen und dem Nutzer anzeigen. Der Nutzer kann die Auswahl beispielsweise durch Änderung der Ausgangsdaten anpassen oder bestätigen. Weiterhin kann der Server mögliche Zusammenstellungen der ausgewählten Einrichtungselemente ermitteln und dem Nutzer beispielsweise in Form eines insbesondere dreidimensionalen Raumplans anzeigen. Durch mehrmaliges Durchlaufen des Verfahrens kann der Nutzer iterativ die für ihn beste Zusammenstellung ermitteln. Anschließend können die ermittelten Daten an ein Einrichtungs- oder Küchenhaus übertragen werden. Vorteilhaft an dieser Ausführungsform ist, dass der Nutzer weniger Zeit im Möbel- oder Küchenhaus verbringen muss und dementsprechend auch weniger betreut werden muss, da der Nutzer einen Großteil der Planung über die Internet-Plattform an einem beliebigen Ort zu einer beliebigen Zeit selbst ausführen kann. Lediglich die Überprüfung und Feinplanung, beispielsweise zur haptischen Materialauswahl oder zum Aufmaß, müssen noch im Einrichtungs- oder Küchenhaus durchgeführt werden.

Die Erfindung betrifft weiterhin ein System zur ergonomischen Auslegung von Kücheneinrichtungen, umfassend wenigstens eine Messeinrichtung, wenigstens ein Sensorsystem und eine Recheneinheit. Erfindungsgemäß ist ein Algorithmus vorgesehen, mittels welchem Daten der aus biometrischen Nutzerdaten gewonnenen einrichtungsspezifischen Datensätze gewichtbar und mit Daten von Küchenelementdatensätzen vergleichbar sind. Die einrichtungsspezifischen Datensätze enthalten die zur ergonomischen Einrichtungsauslegung für den oder die Nutzer relevanten Soll-Daten wie beispielsweise Griffposition, Höhe, Tiefe, Einbauhöhe und/oder Sockeltiefe. Die Küchenelementdatensätze enthalten für jedes Küchenelement die möglichen zu den Soll-Daten korrespondierenden Ist-Daten und können insbesondere auch Daten zur Kompatibilität einzelner Küchenelemente untereinander enthalten. Vorteilhaft sind in einer Datenbank verschiedene Küchenelemente in dazugehörigen Datensätzen hinterlegt. Um das passende Küchenelement für die jeweiligen biometrischen Daten zu finden, vergleicht der Algorithmus die Datensätze und wählt die Elemente aus, welche am besten zu den gemessenen Daten passen. Weiterhin ist es möglich, dass der Algorithmus einzelne Daten der einrichtungsspezifischen Datensätze gewichtet, um z.B. bei Nutzern mit Sehschwäche nur solche Küchengeräte in die Auswahl aufzunehmen, die große und/oder erstastbare Armaturen und Bedienelemente, insbesondere mit erstastbaren Symbolen gekennzeichnete Bedienelemente, aufweisen. Der erfindungsgemäße Algorithmus erlaubt auf effiziente Weise eine umfassende Auslegung einer Kücheneinrichtung anhand biometrischer Nutzerdaten, sodass die Kücheneinrichtung für eine gefahrlose Nutzung an den oder die Nutzer angepasst wird.

In einer vorteilhaften Ausführung des Systems sind Einzelelemente der Kücheneinrichtung je nach Funktion durch den Algorithmus auswählbar. Auf Grundlage der biometrischen Daten wählt der Algorithmus diejenigen Teile aus, welche den Anforderungen genügen und welche an die gemessenen Daten angepasst sind. So wird beispielsweise aufgrund der Ellenbogenhöhe ein Element ausgewählt, welches die entsprechende Höhe aufweist, um dem Kunden eine optimale Arbeitshöhe zu ermöglichen.

Weiterhin ist bevorzugt die Kompatibilität der ausgewählten Teile zueinander durch den Algorithmus prüfbar. Eine Kompatibilitätsprüfung ist unabdingbar, da die Teile zunächst unabhängig voneinander lediglich nach Funktionalität ausgewählt werden. Allerdings müssen die ausgewählten einzelnen Teile zusammenfügbar sein und gegebenenfalls auch zusammenwirken, um eine Benutzung der Kücheneinrichtung zu ermöglichen. Demnach kann der Algorithmus prüfen, ob die Teile beispielsweise miteinander verbindbar sind und/oder ob die ausgewählten elektrischen Geräte in die vorgeschlagenen Teile einbaubar bzw. in diesen betreibbar sind.

Bevorzugt ist der Algorithmus als ein vorzugsweise selbstlernender Optimierungsalgorithmus ausgestaltet. Der Optimierungsalgorithmus wählt anhand der gemessenen Parameter die optimalen Einrichtungsgegenstände und fügt diese zu wenigstens einem Vorschlag zusammen. Besonders bevorzugt erstellt der Optimierungsalgorithmus mehrere passende Lösungsvorschläge, aus welchen der Kunden den von ihm bevorzugten auswählt.

Das System kann eine Anzahl verstellbarer Einrichtungsgegenstände umfassen. Die Einrichtungsgegenstände können beispielsweise Küchenmöbel umfassen, deren Griffposition, Höhe, Tiefe, Einbauhöhe und/oder Sockeltiefe verstellbar sind. Die Einrichtungsgegenstände können insbesondere dazu ausgelegt sind, die einrichtungsspezifischen Daten eines Nutzers bezüglich der Einstellmöglichkeiten zu erfassen, indem der Nutzer verschiedene mögliche Einstellungen ausprobiert bis die Einrichtungsgegenstände passend eingestellt sind. Stellt der Nutzer beispielsweise eine Arbeitsplattenhöhe für sich passend ein, wird dadurch das einrichtungsspezifische Datum "Arbeitsplattenhöhe" für die Küchenelementauswahl festgelegt. Vorteilhafterweise sind die Einrichtungsgegenstände dazu ausgelegt, automatisch, beispielsweise mittels Elektromotoren, verstellt zu werden. Insbesondere ist denkbar, dass die Einrichtungsgegenstände eine Datenschnittstelle umfassen, die dazu ausgelegt ist, aus biometrischen Daten eines Nutzers ermittelte einrichtungsspezifische Daten von einer Recheneinheit entgegenzunehmen, sodass die Einrichtungsgegenstände automatisch zu den biometrischen Daten passend eingestellt werden können. Insbesondere können die Einrichtungsgegenstände dazu ausgelegt sein, dass der Nutzer ausgehend von dieser automatischen Einstellung eine weitere Feineinstellung vornimmt. Der Vorteil verstellbarer Einrichtungsgegenstände liegt darin, dass der Nutzer oder die Nutzergruppe unmittelbar erfahren kann, wie sich unterschiedliche Einrichtungseinstellungen auf sein oder ihr Nutzungserlebnis auswirken. Insbesondere bei inhomogenen Nutzergruppen können so die einzelnen Nutzer herausfinden, wie weit sie sich von ihren jeweiligen Optimaleinstellungen ohne deutliche Komforteinbußen entfernen können, um eine Kompromisseinstellung zu finden, die möglichst allen Nutzern gerecht wird.

Die Erfindung verwirklicht eine einheitliche Idee zur Küchenauslegung. Daher sind Merkmale, die im Kontext der erfindungsgemäßen Vorrichtung, des Systems oder des Verfahrens genannt werden, auch auf die anderen Gegenstände der Erfindung anwendbar. Die Erfindung kann auf beliebige Einrichtungssituationen angewendet werden, wie z. B. Wohn-, Bade- oder Schlafzimmereinrichtungen, Einrichtungen von Innenräumen von Mobilien, wie Autos, LKW, Schiffen, Wohnwagen oder Flugzeugen, oder auf die Einrichtung von Spezialräumen, wie Laboratorien oder Reinräumen.

Weitere Vorteile und Ausführungsformen ergeben sich aus den beigefügten Zeichnungen. Darin aufgeführte technische Merkmale werden auch isoliert von ihrer nur beispielhaft aufgeführten Merkmalskombination beansprucht. Technische Merkmale mit gleicher oder ähnlicher Wirkung werden mit demselben Bezugszeichen gekennzeichnet. Aus Gründen der Übersichtlichkeit wird von der Kennzeichnung mit Bezugszeichen von wiederholt abgebildeten technischen Merkmalen teilweise verzichtet.

Es zeigen:
- Fig. 1:: eine schematische Darstellung einer erfindungsgemäßen Vorrichtung;
- Fig. 2:: eine Seitenansicht einer beispielhaften Ausgestaltung der erfindungsgemäßen Vorrichtung;
- Fig. 3:: ein beispielhaftes Diagramm zur Ermittlung einrichtungsspezifischer Daten aus biometrischen Nutzerdaten;
- Fig. 4:: ein weiteres beispielhaftes Diagramm zur Ermittlung einrichtungsspezifischer Daten aus biometrischen Nutzerdaten und
- Fig. 5:: eine schematische Darstellung eines beispielhaften Verfahrens zur computergestützten Erhebung von einrichtungsbezogenen biometrischen Daten zur ergonomischen Auslegung von Kücheneinrichtungen.

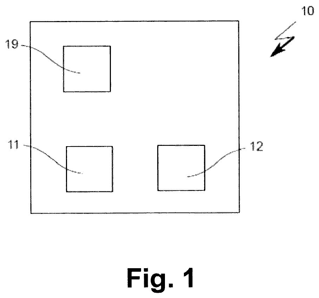

Figur 1 zeigt eine schematische Darstellung einer erfindungsgemäßen Vorrichtung 10, welche ein Sensorsystem 11 und eine Messeinrichtung 12 umfasst. Die Messeinrichtung 12 dient der Messung von biometrischen Daten. Das Sensorsystem 11 weist mehrere Sensoren 11A, 11 B, 11C auf, welche die gemessenen Daten automatisch erfassen. Weiterhin ist auch eine Einrichtung 19 zur Dateneingabe in der Vorrichtung 10 vorgesehen.

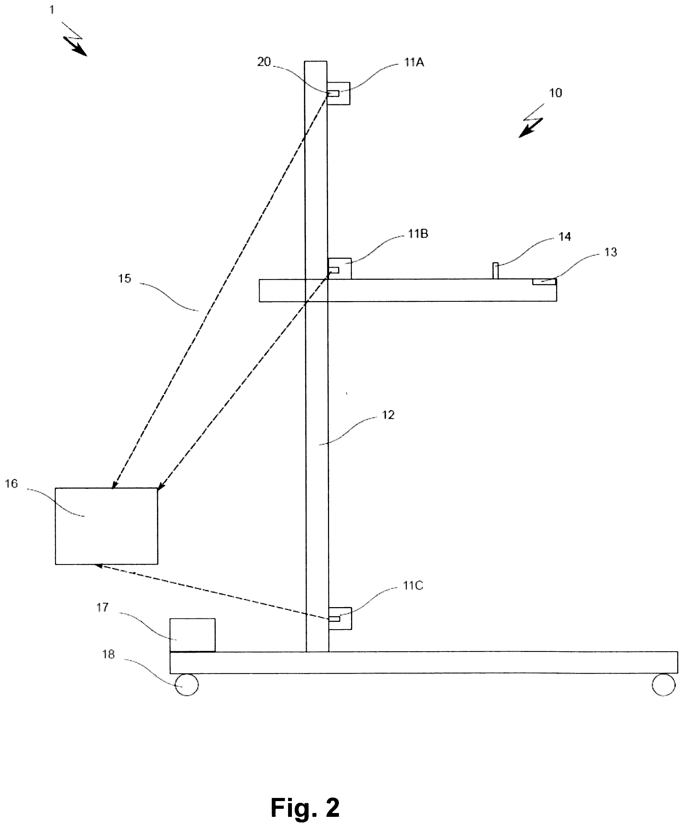

Figur 2 zeigt eine Seitenansicht einer beispielhaften Ausgestaltung der erfindungsgemäßen Vorrichtung 10. Hierbei sind mehrere Sensoren 11 A, 11 B, 11C entlang der Messeinrichtung 12 angeordnet, welche bevorzugt verschiebbar an der Messeinrichtung angeordnet sind. Dabei dient Sensor 11A bevorzugt der Erfassung der gesamten Körpergröße. Sensor 11 B kann zum einen die Ellenbogenhöhe, Armlänge und/oder Fingerlänge erfassen. Weiterhin sind eine Auflage 13 für die Handballen und ein Schieber 14 vorgesehen, mittels welchen die Fingerlänge gemessen werden kann. Über den Sensor 11C ist es möglich die Hüfthöhe, Beinlänge und/oder die Schrittlänge zu messen. Alle Daten, welche von den Sensoren 11A, 11 B, 11C erfasst wurden, werden mittels einer Datenschnittstelle 20 über eine kabellose oder kabelgebundene Datenverbindung 15 an eine Recheneinheit 16 weitergeleitet und dort von einem Algorithmus ausgewertet. Die gesamte Vorrichtung 10 in Verbindung mit der Recheneinheit 16 bildet das System 1. In der Recheneinheit 16 ist ein Algorithmus implementiert, welcher die übermittelten Daten verarbeitet und mit gespeicherten Datensätzen vergleicht. An der Vorrichtung 10 sind weiterhin bevorzugt Rollen 18 angebracht, um die Vorrichtung 10 mobil auszugestalten. Zudem ist beispielsweise ein Elektromotor 17 vorgesehen, welcher ein Verschieben der Vorrichtung 10 erleichtert. Die hier aufgeführte Anzahl an Sensoren ist nur beispielhaft. Es können weitere Sensoren vorgesehen sein, welche jeweils zur Erfassung von bestimmten biometrischen Daten ausgestaltet sind. So kann beispielsweise für jede Messgröße ein separater Sensor an der Messeinrichtung 12 angeordnet sein.

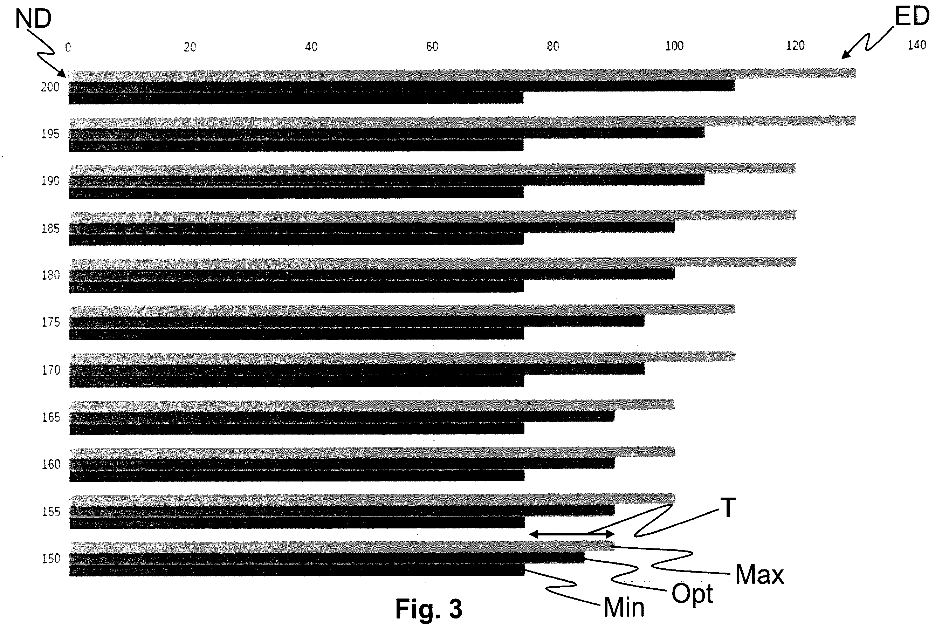

Figur 3 zeigt ein Diagramm zur Ermittlung einrichtungsspezifischer Daten aus biometrischen Nutzerdaten am Beispiel der aus der Körpergröße eines Nutzers ermittelten optimalen Arbeitsplattenhöhe. Dargestellt sind zu jedem Wert eines Nutzerdatums BD, hier der Körpergröße in cm, mit je einem Balken der obere Warnbereich Max, der Optimalbereich Opt und der untere Warnbereich Min eines korrespondierenden Einrichtungsdatums ED, hier der Arbeitsplattenhöhe in cm. Die einzelnen Bereiche sind nur am Beispiel der Körpergröße 150 cm exemplarisch beschriftet. Im Idealfall sollte die Arbeitsplattenhöhe im Optimalbereich für einen Nutzer liegen. Bei mehreren Nutzern mit unterschiedlichen Körpermaßen kann aber auch eine andere Arbeitsplattenhöhe im Toleranzbereich T vom unteren Warnbereich bis zum oberen Warnbereich gewählt werden, um einen Kompromiss zu finden, der den unterschiedlichen Anforderungen möglichst aller Nutzer gerecht wird.

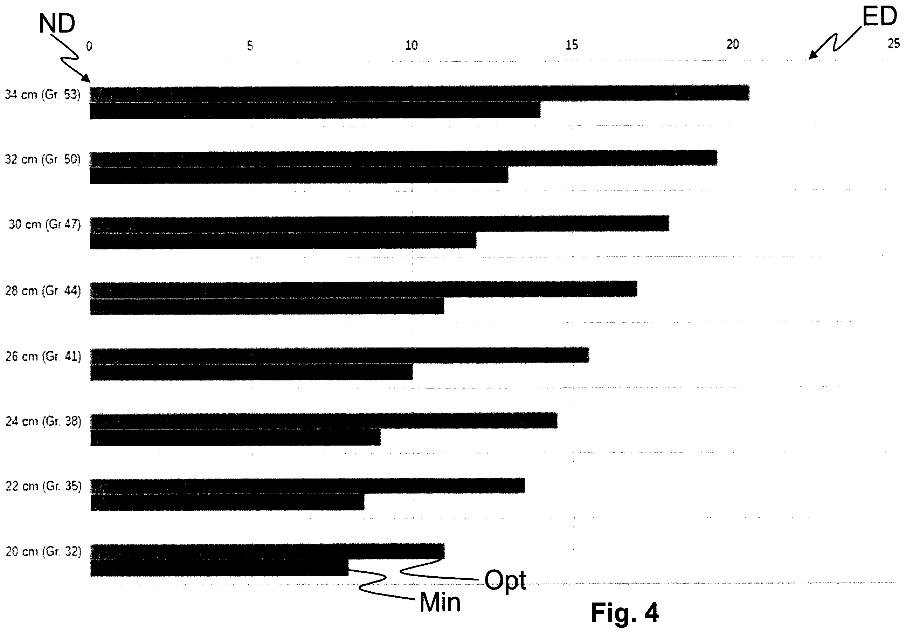

Figur 4 zeigt ein Diagramm zur Ermittlung einrichtungsspezifischer Daten aus biometrischen Nutzerdaten am Beispiel der aus der Fußlänge oder Schuhgröße eines Nutzers ermittelten optimalen Sockeltiefe. Dargestellt sind zu jedem Wert eines Nutzerdatums BD, hier der Fußlänge in cm, beziehungsweise Schuhgröße, mit je einem Balken der Optimalbereich Opt und der untere Warnbereich Min eines korrespondierenden Einrichtungsdatums ED, hier der Sockeltiefe in cm. Die einzelnen Bereiche sind nur am Beispiel der Fußlänge 20 cm exemplarisch beschriftet. Der obere Warnbereich entfällt hier, da die Sockeltiefe aus ergonomischen Gesichtspunkten nicht zu groß sein kann. Die Werte für die Sockeltiefen ergeben sich zu 40 % der Fußlänge als unterer Warnbereich und 60 % der Fußlänge als Optimalbereich, wenn man davon ausgeht, dass etwa die Hälfte der Fußlänge auf die Dicke des Beinansatzes entfällt.

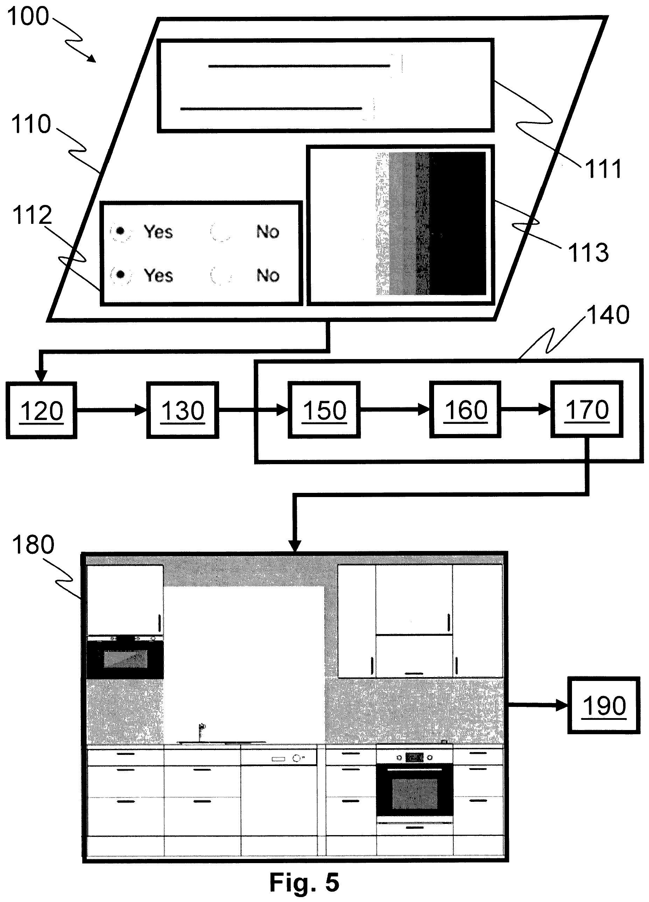

Figur 5 zeigt eine schematische Darstellung eines beispielhaften Verfahrens 100 zur computergestützten Erhebung von einrichtungsbezogenen biometrischen Daten zur ergonomischen Auslegung von Kücheneinrichtungen. Das Erheben 110 von biometrischen Daten und/oder nutzerbezogener Zusatzdaten erfolgt beispielsweise über eine Internetseite, auf der ein Nutzer beispielsweise über Schieberegler 111 seine biometrischen Daten wie Körpermaße, Seh- und/oder Hörfähigkeit, seine Preisvorstellungen und/oder die Raummaße der einzurichtenden Küche eingeben kann. Des Weiteren kann der Nutzer beispielsweise über Auswahlschalter 112 weiter Optionen wie Barrierefreiheit der Kücheneinrichtung und/oder beispielsweise über Farbpaletten 113 Präferenzen bezüglich der Farb- und/oder Materialauswahl eingeben. Anschließend erfolgt das Speichern 120 der Daten in einem individuellen Datensatz, beispielsweise lokal in dem vom Benutzer eingesetzten Endgerät, beispielsweise einem Laptop. Daraufhin findet die Übermittlung 130 des erhobenen Datensatzes an eine Recheneinheit, beispielsweise einen mit dem Internet verbundenen Server statt.

Diese Recheneinheit kann dann das Auswerten 140 des Datensatzes zur Auslegung der Einrichtung durchführen. Als erster Schritt des Auswertens 140 kann das computergestützte Optimieren 150 einer Zuordnung von erhobenen Datensätzen zu einrichtungsspezifischen Datensätzen erfolgen, wobei beispielsweise aus den erhobenen Nutzerdatensätzen einrichtungsspezifische Datensätze mit zur ergonomischen Einrichtungsauslegung für den oder die Nutzer relevanten Soll-Daten wie beispielsweise Griffposition, Höhe, Tiefe, Einbauhöhe und/oder Sockeltiefe ermittelt wird. Neben biometrischen Daten können auch weitere Nutzerdaten wie Farbpräferenzen, Materialpräferenzen und/oder Preisvorstellungen in die einrichtungsspezifischen Datensätze einfließen. Als nächste Schritte des Auswertens 140 können die Auswahl 160 und Zusammenstellung 170 von Einrichtungselementen, die insbesondere den zuvor ermittelten einrichtungsspezifischen Datensätzen entsprechen und untereinander kompatibel sind, erfolgen. Im Anschluss an das Auswerten 140 kann die Darstellung 180 eines Raumplans oder mehrerer alternativer Raumpläne für den Nutzer über die Internetseite stattfinden, sodass der Nutzer sofort einen Gesamteindruck des Auswertungsergebnisses erhält. Insbesondere kann dabei eine Anzahl von Arrangementvorschlägen dynamisch und gegebenenfalls sogar in Echtzeit an die vom Nutzer eingegebenen Daten, vorteilhafterweise in Kombination mit einer Verfügbarkeitsinformation, angepasst werden.

Die Auslegung von Kücheneinrichtungen kann durch mehrmaliges Durchlaufen des Verfahrens 100 und/oder durch die Möglichkeit manueller Eingriffe des Nutzers in die Auswahl 160 und/oder Zusammenstellung 170 optimiert werden. Am Ende der Auslegung kann eine Übertragung 190 von biometrischen Daten, weiteren Nutzerdaten und Auswertungsergebnissen beispielsweise an ein Küchenhaus stattfinden, in dem die weitere Feinplanung und schließlich der Kauf einer der Auslegung entsprechenden Kücheneinrichtung durchgeführt werden können.

Weiterhin kann in einem erfindungsgemäßen Verfahren der Server, der das Auswerten 140 vornimmt, mit einer Datenbank, wie zum Beispiel einem Warenwirtschaftssystem oder einer oder mehrerer aggregierter Online-Datenbanken, eines Küchenhauses oder Küchenherstellers verbunden sein, sodass die Verfügbarkeit von Einrichtungselementen, Kostenprognosen, Transportkapazitäten und/oder Montagekapazitäten in das Auswerten 140 mit einfließen können. Daraus ergibt sich der Vorteil, dass zu jedem Auslegungsergebnis ein prognostizierter Liefertermin und/oder Preis berechnet und dem Nutzer zusammen mit dem Auslegungsergebnis angezeigt werden kann.

### Bezugszeichenliste

- 1: System
- 10: Vorrichtung
- 11: Sensorsystem
- 11A, 11B, 11C: Sensoren
- 12: Messeinrichtung
- 13: Handauflage
- 14: Schieber
- 15: Datenverbindung
- 16: Recheneinheit
- 17: Elektromotor
- 18: Rolle
- 19: Einrichtung zur Dateneingabe
- 20: Datenschnittstelle
- 100: Verfahren
- 110: Erheben
- 111: Schieberegler
- 112: Auswahlschalter
- 113: Farbpalette
- 120: Speichern
- 130: Übermittlung
- 140: Auswerten
- 150: computergestütztes Optimieren
- 160: Auswahl
- 170: Zusammenstellung
- 180: Darstellung
- 190: Übertragung
- ED: Einrichtungsdatum
- Max: oberer Warnbereich
- Min: unterer Warnbereich
- ND: Nutzerdatum
- Opt: Optimalbereich
- T: Toleranzbereich

## Patentansprüche

1. Vorrichtung (10) zur Erhebung von einrichtungsbezogenen biometrischen Daten zur ergonomischen Auslegung von Kücheneinrichtungen, wobei die Vorrichtung (10) eine Messeinrichtung (12) zum Messen von biometrischen Daten aufweist,**dadurch gekennzeichnet, dass**
die durch die Vorrichtung (10) gemessenen biometrischen Daten eine Körpergröße, Schulterhöhe, Greifhöhe, Schritthöhe, Tibialhöhe und/oder Fußlänge umfassen.

2. Vorrichtung (10) nach Anspruch 1,
**dadurch gekennzeichnet, dass**
die durch die Vorrichtung (10) gemessenen biometrischen Daten eine Ellbogenhöhe, Armlänge, Schuhgröße, Hüfthöhe, Oberkörpergröße, Sehkraft, Hörvermögen und/oder Fingerlänge umfassen.

3. Vorrichtung (10) nach einem der vorangegangenen Ansprüche,
**dadurch gekennzeichnet, dass**
die Vorrichtung (10) ein Sensorsystem (11) zur automatischen Erfassung der gemessenen Daten mit einer Datenschnittstelle aufweist, wobei die Datenschnittstelle zur Übertragung der erhobenen Daten an eine Recheneinheit (16) ausgestaltet ist oder das Sensorsystem (11) mit der Recheneinheit (16) eine Einheit bildet.

4. Vorrichtung (10) nach Anspruch 3,
**dadurch gekennzeichnet, dass**
die Daten kabellos oder kabelgebunden übertragbar sind.

5. Vorrichtung (10) nach einem der vorangegangenen Ansprüche,
**dadurch gekennzeichnet, dass**
die Vorrichtung (10) stationär oder mobil ausgestaltet ist.

6. Vorrichtung (10) nach einem der vorangegangenen Ansprüche,
**dadurch gekennzeichnet, dass**
die Vorrichtung (10) eine Einrichtung (19) zur Dateneingabe aufweist.

7. Verwendung der Vorrichtung (10) zur ergonomischen Auslegung von Kücheneinrichtungen,
**dadurch gekennzeichnet, dass**
die Vorrichtung (10) nach einem der Ansprüche 1 bis 6 ausgestaltet ist.

8. Verfahren (100) zur computergestützten Erhebung von einrichtungsbezogenen biometrischen Daten zur ergonomischen Auslegung von Kücheneinrichtungen, wobei das Verfahren (100) zumindest die folgenden Schritte umfasst:
- Erheben (110) von biometrischen Daten;
- Speichern (120) der Daten in einem individuellen Datensatz;
- Übermittlung (130) des erhobenen Datensatzes an eine Recheneinheit;
- Auswerten (140) des Datensatzes zur Auslegung einer Einrichtung;
- computergestütztes Optimieren (150) einer Zuordnung von erhobenen Datensätzen zu einrichtungsspezifischen Datensätzen und
- Auswahl (160) und Zusammenstellung (170) von zumindest einem Arrangement von Einrichtungselementen.

9. Verfahren (100) nach Anspruch 8,
**dadurch gekennzeichnet, dass**
die biometrischen Daten eine Ellenbogenhöhe, Körpergröße, Schulterhöhe, Greifhöhe, Schritthöhe, Tibialhöhe und/oder Fußlänge umfassen:

10. Verfahren (100) nach Anspruch 9,
**dadurch gekennzeichnet, dass**
das Resultat der Auslegung als Darstellung (180) eines bevorzugt dreidimensionalen Raumplans visualisiert wird, in dem bevorzugt Bereiche, die für einen Nutzer nicht und/oder nur unter Fehlbelastungen erreichbar sind und/oder Gefahrenquellen darstellen, als Warnzonen markiert werden.

11. Verfahren (100) nach einem der Ansprüche 9 oder 10,
**dadurch gekennzeichnet, dass**
nach der Auswahl (160) die Küchenelemente manuell an spezielle Anforderungen angepasst werden und/oder ein Bewerten der Auswahl, bevorzugt bezüglich einer Nutzungssicherheit, technischen Kompatibilität und/oder Kompatibilität zu biometrischen Nutzerdaten und/oder nutzerbezogenen Zusatzdaten, erfolgt.

12. Verfahren (100) nach einem der Ansprüche 9 bis 11,
**dadurch gekennzeichnet, dass**
neben biometrischen Daten nutzerbezogene Zusatzdaten erhoben und/oder verarbeitet werden, die für die Auslegung einer Einrichtung relevant sind.

13. Verfahren (100) nach einem der Ansprüche 9 bis 12,
**dadurch gekennzeichnet, dass**
die biometrischen Daten und/oder Zusatzdaten von einer Nutzergruppe mit einer Mehrzahl von Nutzern erhoben werden, wobei bevorzugt eine Wichtung unter den Nutzern besonders bevorzugt als bezogen auf den Nutzzweck der Kücheneinrichtung wichtige Parameter der einzelnen Nutzer vorgenommen wird.

14. Verfahren (100) nach einem der Ansprüche 9 bis 13,
**dadurch gekennzeichnet, dass**
die biometrischen Daten und/oder Zusatzdaten zusammen mit den Auswertungsergebnissen in einer Datenbank gespeichert werden.

15. Verfahren (100) nach einem der Ansprüche 9 bis 14,
**dadurch gekennzeichnet, dass** es auf einer Internet-Plattform ausgeführt wird, wobei bevorzugt das Erheben (110) biometrischer Daten und/oder Zusatzdaten durch Eingaben eines Nutzers über einen Internet-Browser erfolgt, und/oder eine Übertragung (190) von biometrischen Daten, Zusatzdaten und/oder Auswertungsergebnissen an ein Einrichtungshaus und/oder Küchenhaus stattfindet.

16. System (1) zur ergonomischen Auslegung von Kücheneinrichtungen, umfassend wenigstens eine Messeinrichtung (12), wenigstens ein Sensorsystem (11) und eine Recheneinheit (16), wobei ein Algorithmus vorgesehen ist, mittels welchem Daten aus biometrischen Nutzerdaten gewonnener einrichtungsspezifischer Datensätze gewichtbar und mit Daten von Küchenelementdatensätzen vergleichbar sind, **dadurch gekennzeichnet, dass**
die einrichtungsspezifischen Datensätze durch computergestütztes Optimieren aus biometrischen Nutzerdaten gewonnen sind.

17. System (1) nach Anspruch 16,
**dadurch gekennzeichnet, dass**
Einzelelemente der Kücheneinrichtung je nach Funktion durch den Algorithmus auswählbar sind.

18. System (1) nach Anspruch 16 oder 17,
**dadurch gekennzeichnet, dass**
die Kompatibilität der ausgewählten Teile zueinander durch den Algorithmus prüfbar ist.

19. System (1) nach einem der Ansprüche 16 bis 18,
**dadurch gekennzeichnet, dass**
der Algorithmus ein Optimierungsalgorithmus, bevorzugt ein selbstlernender Algorithmus, ist.

20. System (1) nach einem der Ansprüche 16 bis 19,
**dadurch gekennzeichnet, dass**
das System (1) eine Anzahl verstellbarer, bevorzugt automatisch verstellbarer, Einrichtungsgegenstände umfasst, die bevorzugt dazu ausgelegt sind, die einrichtungsspezifischen Daten eines Nutzers bezüglich der Einstellmöglichkeiten zu erfassen.
